# EUROPÄISCHE PATENTSCHRIFT

(11) **EP 3 470 797 B1**
(45) Veröffentlichungstag und Bekanntmachung des Hinweises auf die Patenterteilung: **25.03.2020**
(21) Anmeldenummer: 18190293.3
(22) Anmeldetag: 22.08.2018
(51) Int. Cl.: G01D 11/24, H01L 31/0203, H05K 1/00

(54) **OPTOELEKTRONISCHER SENSOR**
OPTOELECTRONIC SENSOR
CAPTEUR OPTOÉLECTRONIQUE

(30) Priorität: 10.10.2017 DE 102017123553
(43) Veröffentlichungstag der Anmeldung: 17.04.2019
(73) Patentinhaber: SICK AG, 79183 Waldkirch (DE)
(72) Erfinder: Edelmann, Georgy, 79194 Gundelfingen (DE); Matthes, Stephan, 79183 Waldkirch (DE); Unruh, Michael, 79183 Waldkirch (DE)

(56) Entgegenhaltungen:
- DE-A1- 19 842 881
- DE-A1-102005 032 453
- DE-A1-102015 208 486
- US-A1- 2004 080 642

## Beschreibung

Die Erfindung betrifft einen optoelektronischer Sensor, vorzugsweise einen optoelektronischen Miniatursensor, umfassend optische und elektronische Bauelemente, welche auf einer einseitig bestückten Leiterplatte positioniert sind.

Optoelektronische Miniatursensoren erfordern einen besonders platzsparenden Leiterplattenaufbau. Besonders wichtig ist dabei die Leiterplattendicke. Bei kleiner werdender Leiterplattendicke sinkt allerdings die mechanische Stabilität der Leiterplatte, wodurch insbesondere COB (Chip-on-Board)-Elektronikbauteile beschädigt werden können.

Aus der DE 10 2005 037 490 A1 ist ein optischer Sensor bekannt, der wenigstens einen Sender, wenigstens einen Empfänger und eine Auswerteeinheit zur Generierung eines Objektfeststellungssignals aufweist. Der Sender und der Empfänger sind dabei auf einer Polymerfolie aufgebracht, die flexibel ausgestaltet ist, wobei die Bereiche mit Sender und Empfänger durch eine Platte versteift werden. Die Bereiche mit dem Sender und dem Empfänger sind jeweils senkrecht zu einem Bereich ausgerichtet, welcher elektronische Bauelemente trägt.

Die DE 198 42 881 A1 offenbart ein als Halbleiterbauelement ausgebildeter Optosensor mit einem isolierenden Gehäuse, Verdrahtungsmitteln, die sich von der Innenseite zur Außenseite des Gehäuses erstrecken, einem optischen Sensorchip aus Halbleitermaterial, der am Boden des Gehäuses befestigt ist, an dem Sensorchip vorgesehenen Anschlußmitteln, Verbindungsmitteln zum Verbinden der Anschlußmittel mit den Verdrahtungsmitteln, einem transparenten Füllstoff, der in das Gehäuse gefüllt ist und die Oberseite des Sensorchips bedeckt, und einer oberhalb des Sensorchips unter Zwischenlage des Füllstoffs angeordneten transparenten Platte. Der transparente Füllstoff steht teilweise mit der Umgebung des Gehäuses in Verbindung, so dass beispielsweise thermisch bedingte Volumenänderungen des Füllstoffs die Funktion des Optosensors nicht beeinträchtigen können.

Die DE 10 2015 208 486 A1 offenbart eine elektronische Komponente und ein Verfahren zur Herstellung einer elektronischen Komponente, wobei eine Leiterplatte mit einem Trägerkörper verbunden wird, die Leiterplatte mit einer Anzahl elektronischer Bauteile bestückt wird und die Leiterplatte mit wenigstens einem Abdeckelement versehen wird, welches die Anzahl elektronischer Bauteile auf der Leiterplatte zumindest teilweise abdeckt. Es ist vorgesehen, dass das wenigstens eine Abdeckelement über ein thermoplastisches Zwischenelement mit der Leiterplatte verbunden wird.

Die DE 10 2005 032 453 A1 offenbart eine optoelektronische Vorrichtung, Sensoranordnung und ein Verfahren zur Herstellung einer optoelektronischen Vorrichtung, wobei zwischen einem Bauelement und einer Platte ein optischtransparentes Passivierungsmaterial angeordnet ist und das Passivierungsmaterial im Wesentlichen auf den Bereich zwischen dem Bauelement und der Platte beschränkt angeordnet ist.

Der Erfindung liegt die Aufgabe zugrunde, einen optoelektronischen Sensor anzugeben, der kostengünstig aufbaubar ist, wobei der Aufbau trotz Verwendung eines platzsparenden Leiterplattenmaterials besonders robust ausgebildet ist.

Erfindungsgemäß ist die Aufgabe dadurch gelöst, dass die dünne Leiterplatte mit einer unbestückten Seite auf einer Stabilisierungsplatte unmittelbar aufliegt, wobei die Stabilisierungsplatte eine Außenwandung des Sensors darstellt. Aufgrund der Verwendung dieser Stabilisierungsplatte ist eine robuste Ausgestaltung des optoelektronischen Miniatursensors bei gleichzeitiger Verwendung einer sehr dünnen platzsparenden Leiterplatte möglich. Bauelemente, die nach der Chip-on-Board-Technologie auf der Leiterplatte gefertigt werden, unterliegen einer besonderen Stabilität. Gleichzeitig kann eine elektrische Verbindung über die Stabilisierungsplatte zu weiteren elektronischen Baueinheiten erfolgen.

Die Stabilisierungsplatte besteht aus Edelmetall. Eine solche Metallplatte erlaubt insbesondere bei der Herstellung von optoelektronischen Miniatursensoren, dass die Dicke der Leiterplatte immer weiter sinken kann und trotzdem eine mechanische Stabilität der Leiterplatte gewährleistet ist.

Die auf der Leiterplatte angeordneten optischen und elektronischen Bauelemente sind mit einer mindestens teilweise transparenten Komponente abgedeckt. Eine solche teilweise transparente Komponente ermöglicht die Ausstrahlung und den Empfang von Lichtsignalen, wobei die optischen Bauelemente beliebig auf der Leiterplatte verteilt werden können. Es kann sich dabei auch um eine vollständig transparente Komponente bzw. vollständig transparente Abdeckung handeln.

Des Weiteren ist Edelmetall besonders korrosionsfest, weshalb der optoelektronische Sensor mit einer solchen Außenwandung auch in aggressiven Medien eingesetzt werden kann.
In einer Variante ist die Stabilisierungsplatte an einem Trägerrahmen oder einem Trägergehäuse befestigt. Der so beschaffene optoelektronische Sensor kann als separater Bestandteil mit weiteren Elektronikbauteilen in Verbindung gebracht werden.

In einer Weiterbildung ist die Stabilisierungsplatte an dem Trägerrahmen oder dem Trägergehäuse umlaufend stoffschlüssig befestigt. Somit lässt sich der optoelektronische Sensor in einem ein Raster bildenden Trägerrahmen oder Trägergehäuse einfach befestigen, wobei die stoffschlüssige Befestigung vorteilhafterweise durch einen Schweißvorgang realisiert wird.

In einer weiteren Variante ist die teilweise transparente Komponente als Gehäuse ausgebildet. Ein solches Gehäuse stellt eine stabile Abdeckung über den elektronischen und optischen Bauelementen dar, so dass eine mechanische Verletzung der Komponenten unterbunden wird.

In einer Weiterbildung erfolgt eine elektrische Anbindung der optischen und elektronischen Bauelemente über eine Leitung, welche mit der Leiterplatte verbunden ist, wobei mindestens eine Verbindungsstelle der Leitung mit der Leiterplatte von der teilweise transparenten Abdeckung abgedeckt ist. Somit wird eine Einwirkung von aggressiven Medien auf die Verbindungsstelle durch die transparente Abdeckung unterbunden. Dadurch bleibt die elektrische Verbindung zwischen dem optoelektronischen Sensor und der Umgebung zuverlässig bestehen.

In einer weiteren Ausführungsform sind die optischen und elektronischen Bauelemente und die Verbindungsstelle der Leitung mit der Leiterplatte durch die teilweise transparente Abdeckung verkapselt. Diese Verkapselung stellt eine besonders dichte Abdeckung dar und verhindert das Eindringen von flüssigen und gasförmigen Medien in die optischen und elektronischen Bauelemente.

In einer Ausführungsform ist die Leiterplatte als Mehrlagenleiterplatte ausgebildet. Dadurch wird eine platzsparende Kontaktierung mehrerer elektrischer und optischer Bauelemente auf der Leiterplatte ermöglicht.

In Weiterbildung der Erfindung ist die Stabilisierungsplatte galvanisch, chemisch oder mit anderen Beschichtungsverfahren auf die Leiterplatte aufgetragen.

Die Erfindung lässt zahlreiche Ausführungsformen zu. Eine davon soll anhand der in der Zeichnung dargestellten Figuren näher erläutert werden.

Es zeigen:
- Fig. 1: einen Querschnitt durch den erfindungsgemäßen optoelektronischen Sensor,
- Fig. 2: eine Draufsicht auf die Vorder- und auf die Unterseite des optoelektronischen Sensors, welcher an einem Trägerrahmen befestigt ist,
- Fig. 3: ein Ausführungsbeispiel für eine transparente Abdeckung des optoelektronischen Sensors.

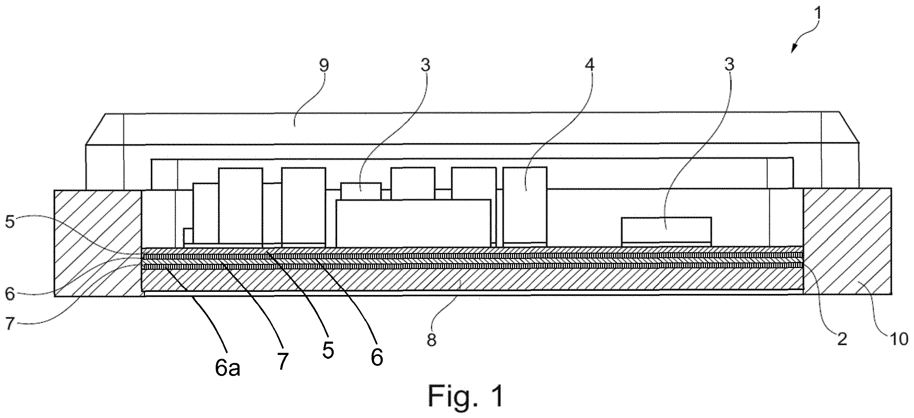

Fig. 1 zeigt ein Ausführungsbeispiel des optoelektronischen Miniatursensors 1 in einem Querschnitt. Dabei sind auf einer Seite einer mehrlagigen Leiterplatte 2 optische Bauelemente 3 und elektronische Bauelemente 4 einseitig angeordnet. Die elektronischen Bauelemente 4 sind auf der Leiterplatte 2 beispielsweise mittels der chip-on-board-Technologie (COB) hergestellt Es sind jedoch auch andere Verfahren möglich.

Die Leiterplatte 2 ist dabei besonders dünn ausgebildet und besteht aus mindestens einer leitenden Kupferschicht 5, 7, zwischen denen jeweils eine Isolierschicht 6 aus einem Harz und Glasfasergewebe ausgebildet ist. Unter der den optischen und elektrischen Bauteilen 3, 4 abgewandten Kupferschicht 7 ist eine Metallplatte 8 angeordnet, beispielsweise ein Metallblech, welches auf die untere Kupferschicht 7 auflaminiert ist. Alternativ wird zwschen der Kupferschicht 7 und der Metallplatte 8 eine weitere Isolier- und Verbindungsschicht 6a angeordnet. Die Seite der Leiterplatte 2, auf welcher die elektronischen und optischen Bauelemente 3, 4 positioniert sind, ist mit einer mindestens in den Bereichen optischer Strahlung transparenten Komponente 9 bzw. Abdeckung abgedeckt, welche die elektrische Strahlung von und zu den optischen Bauelementen 3 durchlässt. Der so ausgestaltete optoelektro-nische Miniatursensor 1 ist an einem Metallrahmen 10 umlaufend angeschweißt.

Ein optoelektronischer Miniatursensor 1 mit diesem Aufbau weist etwa nur die Hälfte bis ein Drittel der Höhe eines konventionell bestückten optoelektronischen Sensors auf, welcher mit einem Gehäuse oder Deckel stabilisiert und geschützt ist und mindestens 1 bis 1,2 mm Bauraumhöhe für die Leiterplatte zusammen mit Deckel- bzw. Gehäusewandung benötigt.

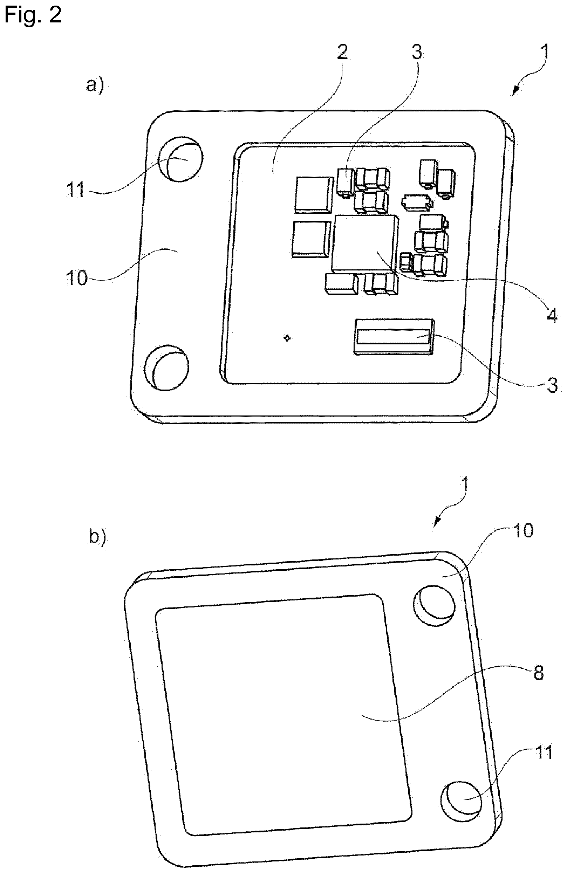

In Fig. 2 ist eine Ansicht auf den optoelektronischen Miniatursensor 1 dargestellt, welcher an dem Metallrahmen 10 befestigt ist. In Fig. 2a ist die Draufsicht und in Fig. 2b die Unterseite des optoelektronischen Miniatursensors 1 gezeigt. Der Metallrahmen 10 weist dabei seitlich zwei Öffnungen 11 auf, an welchen der optoelektronische Miniatursensor 1, der unzentriert auf der Metallplatte 8 angeordnet ist, an dem vorgesehenen Einsatzort montiert werden kann. Auf der Unterseite schließt die Metallplatte 8 schlüssig oder optional aus Toleranzgründen leicht vertieft mit dem Metallrahmen 10 ab.

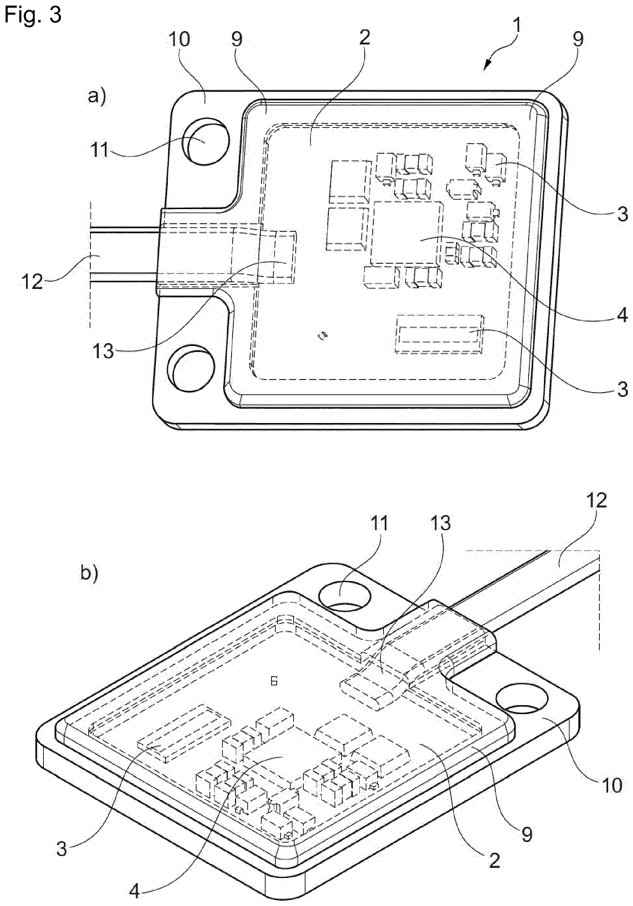

Wie in Fig. 3a und 3b dargestellt, sind die optischen Bauelemente 3 und die elektronischen Bauelemente 4 über eine Leitung 12 mit der Umgebung elektrisch verbunden. Zu diesem Zweck ist die Leitung 12 mit einem Leitungsende 13 mit der Leiterplatte 2 verbunden. Diese Verbindungsstelle zwischen dem Leitungsende 13 und der Leiterplatte 2 ist ebenfalls von der mindestens teilweise transparenten Komponente 9 bzw. Abdeckung umgeben. Die Komponente 9 ist dabei so ausgebildet, dass die auf der Leiterplatte 2 befestigten Bauelemente 3, 4 und das Leitungsende 13 mit dem Abdeckungsmaterial verkapselt sind, so dass eine besonders dichte Abdeckung der einzelnen Bauteile 3, 4, 13 erfolgt.

Die vorgeschlagene Lösung erlaubt neben einer Platzersparnis und einer besseren Bauraumausnutzung gleichzeitig eine besonders hohe mechanische Stabilität und Robustheit des optoelektronischen Miniatursensors 1, welcher in wenigen Montageschritten und bei geringeren Toleranzen herstellbar ist.

## Patentansprüche

1. Optoelektronischer Sensor, vorzugsweise ein optoelektronischer Miniatursensor, umfassend optische und elektronische Bauelemente (3, 4), welche auf einer einseitig bestückten Leiterplatte (2) positioniert sind, **dadurch gekennzeichnet, dass** die dünne Leiterplatte (2) mit einer unbestückten Seite auf einer Stabilisierungsplatte (8) unmittelbar aufliegt, wobei die Stabilisierungsplatte (8) eine Außenwandung des Sensors (1) bildet, **dadurch gekennzeichnet, dass** die Stabilisierungsplatte (8) aus Edelmetall besteht, wobei die auf der Leiterplatte (2) angeordneten optischen und elektronischen Bauelemente (3, 4) mit einer mindestens teilweise transparenten Komponente (9) abgedeckt sind.

2. Optoelektronischer Sensor nach Anspruch 1, **dadurch gekennzeichnet, dass** die Stabilisierungsplatte (8) an einem Trägerrahmen (10) oder einem Trägergehäuse befestigt ist.

3. Optoelektronischer Sensor nach Anspruch 2, **dadurch gekennzeichnet, dass** die Stabilisierungsplatte (8) an dem Trägerrahmen (10) oder dem Trägergehäuse umlaufend stoffschlüssig befestigt ist.

4. Optoelektronischer Sensor nach Anspruch 1, **dadurch gekennzeichnet, dass** die Komponente (9) als Gehäuse ausgebildet ist.

5. Optoelektronischer Sensor nach mindestens einem der vorhergehenden Ansprüche, **dadurch gekennzeichnet, dass** eine elektrische Anbindung der optischen und elektronischen Bauelemente (3, 4) mit einer Leitung (12) erfolgt, welche mit der Leiterplatte (2) verbunden ist, wobei mindestens eine Verbindungsstelle (13) der Leitung (12) mit der Leitungsplatte (2) von der Komponente (9) abgedeckt ist.

6. Optoelektronischer Sensor nach Anspruch 1 oder 5, **dadurch gekennzeichnet, dass** die optischen und elektronischen Bauelemente (3, 4) und/oder die Verbindungsstelle (13) der Leitung (12) mit der Leiterplatte (2) durch die Komponente (9) verkapselt sind.

7. Optoelektronischer Sensor nach mindestens einem der vorhergehenden Ansprüche, **dadurch gekennzeichnet, dass** die Leiterplatte (2) als Mehrlagenleiterplatte ausgebildet ist.

8. Optoelektronischer Sensor nach mindestens einem der vorhergehenden Ansprüche, **dadurch gekennzeichnet, dass** die Stabilisierungsplatte (8) galvanisch, chemisch oder mit anderen Beschichtungsverfahren auf die Leiterplatte (2) aufgetragen ist.

## Claims

1. An optoelectronic sensor, preferably an optoelectronic miniature sensor, comprising optical and electronic elements (3, 4) that are positioned on a circuit board (2) mounted on one side, **characterized in that** an unmounted side of the thin circuit board (2) lies directly on a stabilization plate (8), with the stabilization plate (8) forming an outer wall of the sensor (1), **characterized in that**: the stabilization plate (8) consists of precious metal, with the optical and electronic elements (3, 4) arranged on the circuit board (2) being covered by an at least partly transparent component (9).

2. An optoelectronic sensor in accordance with claim 1, **characterized in that** the stabilization plate (8) is fastened to a support frame (10) or to a support housing.

3. An optoelectronic sensor in accordance with claim 2, **characterized in that** the stabilization plate (8) is fastened to the support frame (10) or to the support housing with material continuity peripherally.

4. An optoelectronic sensor in accordance with claim 1, **characterized in that** the component (9) is configured as a housing.

5. An optoelectronic sensor in accordance with at least one of the preceding claims, **characterized in that** an electrical connection of the optical and electronic elements (3, 4) takes place to a line (12) that is connected to the circuit board (2), with at least one connection point (13) of the line (12) to the circuit board (2) being covered by the component (9).

6. An optoelectronic sensor in accordance with claim 1, or claim 5, **characterized in that** the optical and electronic elements (3, 4) and/or the connection point (13) of the line (12) to the circuit board (2) are/is encapsulated by the component (9).

7. An optoelectronic sensor in accordance at least one of the preceding claims, **characterized in that** the circuit board (2) is configured as a multilayer circuit board.

8. An optoelectronic sensor in accordance with at least one of the preceding claims, **characterized in that** the stabilization plate (8) is applied to the circuit board (2) galvanically, chemically, or by other coating processes.

## Revendications

1. Capteur optoélectronique, de préférence capteur optoélectronique miniature, comprenant des composants optiques et électroniques (3, 4) qui sont positionnés sur une carte à circuit imprimé (2) simple face, **caractérisé en ce que** la carte à circuit imprimé mince (2) repose par la face non équipée directement sur une plaque de stabilisation (8), la plaque de stabilisation (8) constituant une paroi extérieure du capteur (1), **caractérisé en ce que** la plaque de stabilisation (8) est constituée en métal précieux, les composants optiques et électroniques (3, 4) disposés sur la carte à circuit imprimé (2) étant recouverts d'un composant (9) au moins partiellement transparent.

2. Capteur optoélectronique selon la revendication 1, **caractérisé en ce que** la plaque de stabilisation (8) est fixée à un cadre porteur (10) ou à un boîtier porteur.

3. Capteur optoélectronique selon la revendication 2, **caractérisé en ce que** la plaque de stabilisation (8) est fixée au cadre porteur (10) ou au boîtier porteur circonférentiellement par coopération de matière.

4. Capteur optoélectronique selon la revendication 1, **caractérisé en ce que** le composant (9) est réalisé sous forme de boîtier.

5. Capteur optoélectronique selon l'une au moins des revendications précédentes, **caractérisé en ce qu'**une connexion électrique des composants optiques et électroniques (3, 4) est réalisée au moyen d'une ligne (12) qui est reliée à la carte à circuit imprimé (2), au moins un emplacement de connexion (13) de la ligne (12) avec la carte à circuit imprimé (2) étant recou-vert par le composant (9).

6. Capteur optoélectronique selon la revendication 1 ou 5, **caractérisé en ce que** les composants optiques et électroniques (3, 4) et/ou l'emplacement de connexion (13) de la ligne (12) avec la carte à circuit imprimé (2) sont en-capsulés par le composant (9).

7. Capteur optoélectronique selon l'une au moins des revendications précédentes, **caractérisé en ce que** la carte à circuit imprimé (2) est conçue comme une carte à circuit imprimé multicouche.

8. Capteur optoélectronique selon l'une au moins des revendications précédentes, **caractérisé en ce que** la plaque de stabilisation (8) est appliquée sur la carte à circuit imprimé (2) par voie galvanique, chimique ou par d'autres procédés de revêtement.
